(19) **Europäisches Patentamt**
**European Patent Office**
**Office européen des brevets**

(11) **EP 4 750 281 A1**

(12) # EUROPEAN PATENT APPLICATION
published in accordance with Art. 153(4) EPC

(43) Date of publication:
**27.05.2026 Bulletin 2026/22**

(21) Application number: **24847485.0**

(22) Date of filing: **05.01.2024**

(51) International Patent Classification (IPC):
**H10K 30/85** (2023.01)    **H10K 71/16** (2023.01)
**H10K 30/88** (2023.01)

(52) Cooperative Patent Classification (CPC):
**H10K 30/85; H10K 30/88; H10K 71/16;**
**Y02E 10/549**

(86) International application number:
**PCT/CN2024/070953**

(87) International publication number:
**WO 2025/025514 (06.02.2025 Gazette 2025/06)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **02.08.2023 CN 202310967008**

(71) Applicant: **Contemporary Amperex Technology Co., Limited**
**Ningde, Fujian 352100 (CN)**

(72) Inventors:
• **MA, Junfu**
  **Ningde, Fujian 352100 (CN)**
• **LIANG, Weifeng**
  **Ningde, Fujian 352100 (CN)**
• **CHEN, Changsong**
  **Ningde, Fujian 352100 (CN)**
• **LIN, Zuchao**
  **Ningde, Fujian 352100 (CN)**
• **GUO, Yongsheng**
  **Ningde, Fujian 352100 (CN)**

(74) Representative: **Kraus & Lederer PartGmbB**
**Thomas-Wimmer-Ring 15**
**80539 München (DE)**

(54) **SOLAR CELL AND MANUFACTURING METHOD THEREFOR, AND ELECTRIC DEVICE**

(57)    The present application provides a solar cell and a manufacturing method therefor, and an electric device. The solar cell comprises: a first electrode layer, an active layer, a second electrode layer and a semi-packaging layer which are sequentially stacked, wherein the semi-packaging layer comprises a plane part located between the active layer and the second electrode layer and a packaging part at least partially located on at least one side surface of the active layer. The plane part of the semi-packaging layer located between the active layer and the second electrode layer can inhibit migration of active ions in the active layer to the second electrode layer, and the packaging part of the semi-packaging layer at least partially located on at least one side surface of the active layer can block external water oxygen, so that degradation of the active layer under the action of water oxygen is reduced, thereby comprehensively improving the stability of the solar cell.

FIG. 1

EP 4 750 281 A1

**Description**

CROSS-REFERENCE

The present application refers to Chinese Patent Application No. 202310967008.4 filed on August 2, 2023, and entitled "SOLAR CELL AND MANUFACTURING METHOD THEREFOR, AND ELECTRIC DEVICE", which is incorporated herein by reference in its entirety.

TECHNICAL FIELD

The present application relates to the technical field of solar cell devices, and in particular, to a solar cell and a manufacturing method therefor, and an electric device.

BACKGROUND

With the large-scale exploitation and utilization of non-renewable energy such as coal and petroleum, the reserves thereof have become insufficient to meet the needs of the development of various industries, such as agriculture and industry. Therefore, renewable energy has gradually emerged as an alternative to non-renewable energy to promote the development of society and industry. Solar cell devices are widely used due to their characteristics, such as being environmentally friendly and capable of outputting electrical energy when exposed to sunlight.

However, solar cells exhibit poor stability and are prone to aging under the external environment, resulting in a significant degradation in device performance and a shortened service life, which limits their further promotion and application.

SUMMARY

The present application provides a solar cell and a manufacturing method therefor, and an electric device. The solar cell has high performance stability.

In a first aspect, embodiments of the present application provide a solar cell. The solar cell includes: a first electrode layer, an active layer, and a second electrode layer that are sequentially stacked, and a semi-encapsulation layer, where the semi-encapsulation layer includes a planar portion located between the active layer and the second electrode layer and an encapsulating portion at least partially located on at least one side surface of the active layer.

The planar portion of the semi-encapsulation layer located between the active layer and the second electrode layer can suppress the migration of active ions in the active layer to the second electrode layer. The encapsulating portion of the semi-encapsulation layer at least partially located on at least one side surface of the active layer can block external water and oxygen, reduce the degradation of the active layer under the action of water and oxygen, and thus comprehensively improve the stability of the solar cell.

In any embodiment, the semi-encapsulation layer includes a semiconductor material.

The inclusion of the semiconductor material in the semi-encapsulation layer facilitates the migration of charge carriers from the active layer to the second electrode layer while suppressing the device efficiency decay and improving the performance stability of the solar cell, thereby enhancing the power conversion efficiency of the solar cell.

In any embodiment, the semi-encapsulation layer is prepared by using an atomic layer deposition method.

The thin film prepared by using the atomic layer deposition method exhibits high density, which can effectively block the diffusion of halide anions in the active layer to the second electrode layer, particularly can alleviate the corrosion of the metal in the second electrode layer caused by halide anions, and prevent the ingress of external water and oxygen into the active layer, thereby effectively improving the performance stability and power conversion efficiency of the solar cell.

In any embodiment, a thickness of the planar portion of the semi-encapsulation layer and/or the encapsulating portion of the semi-encapsulation layer is 5 nm to 35 nm.

In any embodiment, a thickness of the planar portion of the semi-encapsulation layer and/or the encapsulating portion of the semi-encapsulation layer is 10 nm to 30 nm.

When the thickness of the semi-encapsulation layer is within an appropriate range, the transport of charge carriers can be facilitated while blocking the transport of ions, and the thermal stability and power conversion efficiency of the solar cell can be simultaneously improved.

In any embodiment, the solar cell is a regular-structure solar cell, the active layer includes an electron transport layer, a perovskite layer, and a hole transport layer that are sequentially stacked, and the hole transport layer is located between the perovskite layer and the semi-encapsulation layer; the semi-encapsulation layer includes a p-type semiconductor material.

The inclusion of the p-type semiconductor material in the semi-encapsulation layer facilitates the migration of holes in the hole transport layer to the second electrode layer while blocking the migration of active ions in the active layer to the second electrode layer and preventing the degradation of the active layer by external water and oxygen, thereby simultaneously improving the performance stability and power conversion efficiency of the regular-structure solar cell.

In any embodiment, the p-type semiconductor material includes at least one of nickel oxide, cuprous oxide, cuprous iodide, silver iodide, and molybdenum oxide.

In any embodiment, the solar cell is an inverted-structure solar cell, the active layer includes a hole transport layer, a perovskite layer, and an electron transport layer that are sequentially stacked, and the electron transport layer is located between the perovskite layer and the semi-encapsulation layer; the semi-encapsulation layer includes an n-type semiconductor material.

The n-type semiconductor material included in the semi-encapsulation layer has a low hole mobility, which can effectively reduce the migration rate of holes. Therefore, the semi-encapsulation layer including the n-type semiconductor material can block holes, reduce charge carrier recombination, reduce leakage current, and enhance the power conversion efficiency of the inverted-structure solar cell while improving the stability of the solar cell.

In any embodiment, the n-type semiconductor material includes at least one of tin dioxide, titanium dioxide, zinc oxide, indium oxide, and gallium oxide.

A second aspect of the present application provides a preparation method for a solar cell. The preparation method includes: providing a first electrode layer and an active layer that are sequentially stacked; preparing a semi-encapsulation layer on an upper side of the active layer and at least one side surface of the active layer, where the semi-encapsulation layer includes a planar portion located on the upper side of the active layer and an encapsulating portion located on at least one side surface of the active layer; and providing a second electrode layer on an upper side of the planar portion of the semi-encapsulation layer.

In any embodiment, the preparation method specifically includes: preparing a semi-encapsulation layer on the upper side of the active layer and at least one side surface of the active layer by using an atomic layer deposition method, where the semi-encapsulation layer includes a semiconductor material.

In any embodiment, the solar cell is a regular-structure solar cell, the active layer includes an electron transport layer, a perovskite layer, and a hole transport layer that are sequentially stacked, and the hole transport layer is located between the perovskite layer and the semi-encapsulation layer; the semi-encapsulation layer includes a p-type semiconductor material.

In any embodiment, the solar cell is an inverted-structure solar cell, the active layer includes a hole transport layer, a perovskite layer, and an electron transport layer that are sequentially stacked, and the electron transport layer is located between the perovskite layer and the semi-encapsulation layer; the semi-encapsulation layer includes an n-type semiconductor material.

A third aspect of the present application provides an electric device. The electric device includes the solar cell according to any embodiment or a solar cell prepared by using the preparation method according to any embodiment.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

BRIEF DESCRIPTION OF THE DRAWINGS

By reading the detailed description of the preferred embodiments below, various additional advantages and benefits will become clear to those of ordinary skill in the art. The drawings are provided solely for the purpose of illustrating the preferred embodiments and shall not be construed as limiting the present application. Furthermore, the same reference numerals in all the drawings denote identical components. In the drawings:

FIG. 1 shows a schematic diagram of a cross-sectional structure of a solar cell according to some embodiments of the present application;

FIG. 2 shows a schematic diagram of a cross-sectional structure of a regular-structure solar cell according to some embodiments of the present application; and

FIG. 3 shows a schematic diagram of a cross-sectional structure of an inverted-structure solar cell according to some embodiments of the present application.

Reference numerals in the detailed description are as follows:

solar cells 1-1, 1-2, and 1-3;

first electrode layer 10;

active layer 11, electron transport layer 111, perovskite layer 112, hole transport layer 113;

second electrode layer 12;

semi-encapsulation layer 13, planar portion 131, encapsulating portion 132.

DETAILED DESCRIPTION

Embodiments of the technical solutions of the present application will be described in detail below with reference to the drawings. The following embodiments are merely used to more clearly illustrate the technical solutions of the present application, and therefore, are only exemplary and do not limit the protection scope of the present application.

Unless otherwise defined, all technical and scientific terms used herein have the same meaning as commonly understood by those skilled in the technical field to which the present application belongs. The terms used herein are only used to illustrate the specific embodiments, rather than limit the present application. The terms "include", "comprise", "have", and "provided with", and any variants thereof in the specification and claims of the present application and the above description of the drawings are intended to cover non-exclusive inclusions.

In the description of the embodiments of the present application, technical terms such as "first" and "second" are only used to distinguish different objects and should not be interpreted as indicating or implying the relative importance or implicitly indicating the number, specific order, or primary and secondary relationship of the technical features referred to. In the description of the embodiments of the present application, unless otherwise specifically defined, "plurality of" means two or more.

Reference in the present application to "embodiment" means that a particular feature, structure, or characteristic described in combination with the embodiment may be included in at least one embodiment of the present application. The references of the word in the context of the specification do not necessarily refer to the same embodiment, nor to separate or alternative embodiments exclusive of other embodiments. It will be explicitly and implicitly understood by those skilled in the art that the embodiments described herein may be combined with other embodiments.

In the description of the embodiments of the present application, the term "and/or" is merely a way to describe the association relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to two or more (including two). Similarly, "plurality of groups" refers to two or more (including two) groups, and "plurality of pieces" refers to two or more (including two) pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", and the like indicate orientations or positional relationships based on those shown in the drawings. They are merely for the convenience of describing the embodiments of the present application and simplifying the description, rather than indicating or implying that the apparatus or element referred to must have a specific orientation or be constructed and operated in the specific orientation, and thus should not be construed as a limitation to the embodiments of the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above terms in the embodiments of the present application may be interpreted according to specific conditions.

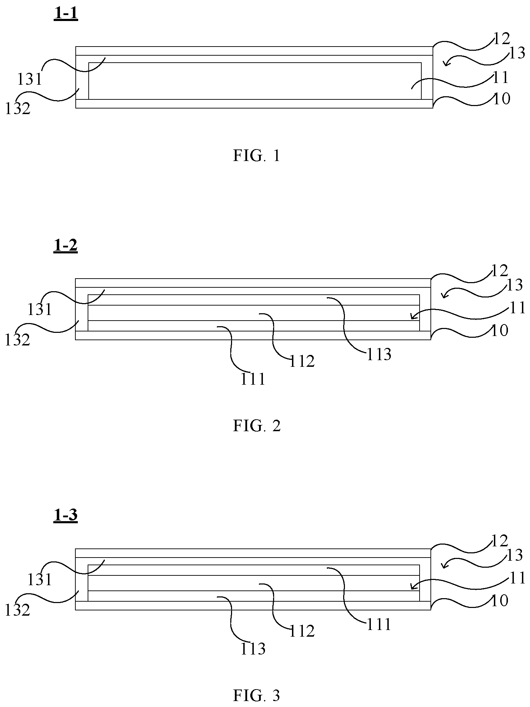

As shown in FIG. 1, a first aspect of the present application provides a solar cell 1-1. The solar cell includes: a first electrode layer 10, an active layer 11, and a second electrode layer 12 that are sequentially stacked, and a semi-encapsulation layer 13. The semi-encapsulation layer 13 includes a planar portion 131 located between the active layer 11 and the second electrode layer 12 and an encapsulating portion 132 located on at least one side surface of the active layer 11.

In some embodiments, the first electrode layer 10 is a transparent electrode layer, and the second electrode layer 12 is a back electrode layer.

In some embodiments, the first electrode layer 10 includes at least one of fluorine-doped tin oxide (FTO), indium tin oxide (ITO), aluminum-doped zinc oxide (AZO), boron-doped zinc oxide (BZO), indium zinc oxide (IZO), and indium tungsten oxide (IWO).

In some embodiments, the thickness of the first electrode layer 10 is 200 nm to 1000 nm. For example, the thickness of the transparent conductive layer may be 200 nm, 300 nm, 400 nm, 500 nm, 600 nm, 700 nm, 800 nm, 900 nm, 1000 nm, or may be within a range formed by any of the above values.

In some embodiments, the second electrode layer 12 is generally a metal electrode, an inorganic electrode, or a metal-inorganic electrode composite conductive material. In some embodiments, the second electrode layer 12 includes at least one of indium tin oxide (ITO), lanthanide-doped indium oxide, boron-doped zinc oxide (BZO), aluminum zinc oxide (AZO), indium zinc oxide (IZO), gallium zinc oxide (GZO), indium tungsten oxide (IWO), Au, Ag, Cu, Al, Ni, Cr, Bi, Pt, Mg, Mo, W, and alloys thereof, graphite, graphene, and a carbon nanotube. In some embodiments, the second electrode layer 12 is Ag, Cu, C, Au, Al, ITO, AZO, BZO, or IZO. In some embodiments, the second electrode layer 12 is Cu, Ag, Au, or a combination thereof.

In some embodiments, the thickness of the second electrode layer 12 is 20 nm to 200 nm. For example, the thickness of the back electrode layer may be 20 nm, 40 nm, 60 nm, 80 nm, 100 nm, 120 nm, 140 nm, 160 nm, 180 nm, 200 nm, or may be within a range formed by any of the above values.

In some embodiments, the solar cell is a perovskite cell, and the active layer includes a perovskite layer.

In some embodiments, the perovskite layer includes a perovskite-type metal halide; the perovskite-type metal halide has a chemical formula of $ABX_3$, where A denotes a monovalent cation, B denotes a divalent cation, and X denotes a monovalent anion. In some embodiments, A includes one or more of $Cs^+$, $K^+$, $Rb^+$, a monovalent amine cation, and a monovalent amidinium cation. In some embodiments, the monovalent amine cation includes $CH_3NH_3^+$ (methylammonium, $MA^+$) and ammonium ($NH_4^+$); the monovalent amidinium cation includes $NH_2CH=NH_2^+$ (formamidinium, $FA^+$). In some embodiments, B includes one or more of $Pb^{2+}$, $Sn^{2+}$, $Fe^{2+}$, $Mn^{2+}$, $Ni^{2+}$, $Ge^{2+}$, $Co^{2+}$, and $Sb^{2+}$. In some embodiments, X includes a halide anion. In some embodiments, X includes at least one of $Cl^-$, $Br^-$, and $I^-$. In some embodiments, the band gap of the perovskite-type metal halide is 1.20 eV to 2.30 eV.

In some embodiments, the thickness of the perovskite layer is 400 nm to 1000 nm. For example, the thickness of the perovskite layer may be 400 nm, 500 nm, 600 nm, 700 nm, 800 nm, 900 nm, 1000 nm, or may be within a range formed by any of the above values. In some embodiments, the thickness of the perovskite layer is 500 nm to 900 nm.

The planar portion 131 of the semi-encapsulation layer 13 located between the active layer 11 and the second electrode layer 12 can suppress the migration of active ions in the active layer 11 to the second electrode layer 12. The encapsulating portion 132 of the semi-encapsulation layer 13 located on at least one side surface of the active layer 11 can block external water and oxygen, reduce the degradation of the active layer 11 under the action of water and oxygen, and thus comprehensively improve the performance stability of the solar cell 1.

In some embodiments, the semi-encapsulation layer 13 includes a semiconductor material.

The semiconductor material refers to a material exhibiting semiconductor properties, and the electrical conductivity thereof is between that of a conductor and an insulator.

In some embodiments, the semiconductor material includes a semiconductor oxide. The semiconductor oxide, also known as an oxide semiconductor, refers to a class of oxides exhibiting semiconductor properties. In some embodiments, the semiconductor oxide includes at least one of tin oxide, titanium oxide, zinc oxide, nickel oxide, and cuprous oxide.

The inclusion of the semiconductor material in the semi-encapsulation layer 13 facilitates the migration of charge carriers from the active layer 11 to the second electrode layer 12 while suppressing the device efficiency decay and improving the performance stability of the solar cell 1, thereby enhancing the power conversion efficiency of the solar cell 1.

In some embodiments, the semi-encapsulation layer 13 is prepared by using an atomic layer deposition method.

The atomic layer deposition method is a method in which substances can be deposited layer by layer on the surface of a substrate in the form of monatomic films.

The thin film prepared by using the atomic layer deposition method exhibits high density, which can effectively block the diffusion of halide anions in the active layer 11 to the second electrode layer 12, particularly can alleviate the corrosion of the metal in the second electrode layer 12 caused by halide anions, prevent the ingress of external water and oxygen into the active layer 11, and prevent the degradation of the active layer, thereby effectively improving the performance stability and power conversion efficiency of the solar cell 1.

Meanwhile, the atomic layer deposition method involves alternately introducing gaseous precursors into a reaction chamber in pulses. During the process, a first reaction precursor is chemisorbed onto the substrate, and when a second precursor is introduced into the reaction chamber, the second precursor reacts with the previous precursor already adsorbed on the surface of the substrate to form a thin film. Therefore, film formation by the atomic layer deposition method is not limited by direction and angle, and the reaction precursor can be freely adsorbed onto any exposed surface of the active layer, enabling simultaneous formation of the semi-encapsulation layer 13 in all directions. The method has the characteristics of high production efficiency and low cost.

Compared with the magnetron sputtering method and the evaporation method commonly used for thin film preparation, the atomic layer deposition method provides higher compactness, precision, and controllability, and the active layer 11 to be deposited does not experience thermal shock under target sputtering, such that the prepared solar cell 1 achieves higher power conversion efficiency and stability.

In some embodiments, the thickness of the planar portion 131 of the semi-encapsulation layer and/or the encapsulating portion 132 of the semi-encapsulation layer is 5 nm to 35 nm. In some embodiments, the thickness of the planar portion 131 of the semi-encapsulation layer and/or the encapsulating portion 132 of the semi-encapsulation layer is 10 nm to 30 nm.

In some embodiments, the thickness of the planar portion 131 of the semi-encapsulation layer and/or the encapsulating portion 132 of the semi-encapsulation layer is 5 nm, 10 nm, 15 nm, 20 nm, 25 nm, 30 nm, 35 nm, or any value therebetween.

In some embodiments, the thicknesses of the planar portion 131 of the semi-encapsulation layer and the encapsulating portion 132 of the semi-encapsulation layer are the same.

When the thickness of the semi-encapsulation layer is within an appropriate range, the transport of charge carriers can be facilitated while blocking the transport of ions, and the thermal stability and power conversion efficiency of the solar cell can be simultaneously improved.

In some embodiments, as shown in FIG. 2, the solar cell 1-2 is a regular-structure solar cell, the active layer 11 includes an electron transport layer 111, a perovskite layer 112, and a hole transport layer 113 that are sequentially stacked, and the hole transport layer 113 is located between the perovskite layer 112 and the semi-encapsulation layer 13; the semi-encapsulation layer 13 includes a p-type semiconductor material.

In the p-type semiconductor material, the major charge carriers are holes.

In some embodiments, the p-type semiconductor material includes at least one of nickel oxide, cuprous oxide, cuprous iodide, silver iodide, and molybdenum oxide.

The inclusion of the p-type semiconductor material in the semi-encapsulation layer 13 facilitates the migration of holes in the hole transport layer 113 to the second electrode layer 12 while blocking the migration of active ions in the active layer 11 to the second electrode layer 12 and preventing the degradation of the active layer 11 by external water and oxygen, thereby simultaneously improving the performance stability and power conversion efficiency of the regular-structure solar cell 1.

In some embodiments, as shown in FIG. 3, the solar cell 1-3 is an inverted-structure solar cell, the active layer 11 includes a hole transport layer 113, a perovskite layer 112, and an electron transport layer 111 that are sequentially stacked, and the electron transport layer 111 is located between the perovskite layer 112 and the semi-encapsulation layer 13; the semi-encapsulation layer 13 includes an n-type semiconductor material.

The n-type semiconductor material is also known as an electron-type semiconductor material, that is, a doped semiconductor material in which the free electron concentration is much higher than the hole concentration.

The n-type semiconductor material included in the semi-encapsulation layer 13 has a low hole mobility, which can effectively reduce the migration rate of holes. Therefore, the semi-encapsulation layer including the n-type semiconductor material can block holes, reduce charge carrier recombination, reduce leakage current, and enhance the power conversion efficiency of the inverted-structure solar cell while improving the stability of the device.

In some embodiments, the n-type semiconductor material includes at least one of tin dioxide, titanium dioxide, zinc oxide, indium oxide, and gallium oxide.

In some embodiments, the electron transport layer 111 includes at least one of the following materials and derivatives thereof: [6,6]-phenyl-C61-butyric acid methyl ester ($PC_{61}BM$), [6,6]-phenyl-C71-butyric acid methyl ester ($PC_{71}BM$), fullerene C60 (C60), fullerene C70 (C70), tin dioxide ($SnO_2$), and zinc oxide (ZnO).

In some embodiments, the hole transport layer 113 includes at least one of the following materials and derivatives thereof: BTPA-series hole transport materials, poly[bis(4-phenyl)(2,4,6-trimethylphenyl)amine] (PTAA), 2,2',7,7'-tetrakis[N,N-di-(4-methoxyphenyl)amino]-9,9'-spirobifluorene (Spiro-OMeTAD), poly(3-hexylthiophene) ($P_3HT$), triphenylamine with a triptycene core ($H_{101}$), 3,4-ethylenedioxythiophenemethoxytriphenylamine (EDOT-OMeTPA), N-(4-aminophenyl)carbazolespirobifluorene (CzPAF-SBF), poly(3,4-ethylenedioxythiophene):poly(styrene sulfonate) (PEDOT:PSS), polythiophene, nickel oxide (NiOx), molybdenum oxide ($MoO_3$), cuprous iodide (CuI), and cuprous oxide ($Cu_2O$).

A second aspect of the present application provides a preparation method for a solar cell. The preparation method includes: providing a first electrode layer and an active layer that are sequentially stacked; preparing a semi-encapsulation layer on an upper side of the active layer and at least one side surface of the active layer, where the semi-encapsulation layer includes a planar portion located on the upper side of the active layer and an encapsulating portion located on at least one side surface of the active layer; and providing a second electrode layer on an upper side of the planar portion of the semi-encapsulation layer.

In some embodiments, the preparation method specifically includes: preparing a semi-encapsulation layer on the upper side of the active layer and at least one side surface of the active layer by using an atomic layer deposition method, where the semi-encapsulation layer includes a semiconductor material.

In some embodiments, the formation method for the semi-encapsulation layer includes using a metal precursor to react with an oxygen precursor to achieve atomic layer deposition, thereby preparing the semiconductor material.

In some embodiments, the metal precursor includes at least one of an organotin precursor, an organonickel precursor, an organocopper precursor, an organozinc precursor, and an organotitanium precursor.

In some embodiments, the oxygen precursor includes at least one of water and ozone.

In some embodiments, the solar cell is a regular-structure solar cell, the active layer includes an electron transport layer, a perovskite layer, and a hole transport layer that are sequentially stacked, and the hole transport layer is located between the perovskite layer and the semi-encapsulation layer; the semi-encapsulation layer includes a p-type semiconductor material.

In some embodiments, the solar cell is an inverted-structure solar cell, the active layer includes a hole transport layer, a perovskite layer, and an electron transport layer that are sequentially stacked, and the electron transport layer is located between the perovskite layer and the semi-encapsulation layer; the semi-encapsulation layer includes an n-type semiconductor material.

A third aspect of the present application provides an electric device. The electric device includes the solar cell according to any embodiment or a solar cell prepared by using the preparation method according to any embodiment.

In some embodiments, the solar cell may be used as the power generation device for the electric device. The type of the power generation device may include, but is not limited to, an integrated power generation mode.

The electric device may include a mobile device, such as a mobile phone, a tablet computer, a notebook computer, a calculator, a watch, a vehicle, an electric train, a ship, a satellite, and a power generation system, but is not limited thereto.

The position of the power generation device may include, but is not limited to, positions such as a roof or a rear panel of a vehicle.

The following examples more specifically describe the content disclosed in the present application. These examples are intended for illustrative purposes only, since various modifications and changes within the scope of the content disclosed in the present application will be apparent to those skilled in the art. Unless otherwise stated, all parts, percentages, and ratios reported in the following examples are based on weight, and all reagents used in the examples are commercially available or synthesized according to conventional methods and can be used directly without further treatment, and the instruments used in the examples are all commercially available.

## Examples

## Preparation Method

Example 1

The embodiments of the present application provide a manufacturing method for a regular-structure solar cell. The manufacturing method includes the following steps.

An FTO conductive glass with a size of 2.0 cm $\times$ 2.0 cm was taken, and both ends of the FTO conductive glass were separately subjected to laser etching to remove 0.35 cm of the FTO to expose the glass substrate.

The etched FTO conductive glass was sequentially ultrasonically cleaned with water, acetone, and isopropanol several times.

The FTO conductive glass was dried with a nitrogen gun to remove the solvent, and was further cleaned in an ultraviolet ozone machine.

The ultraviolet ozone-treated FTO substrate was spin-coated with a $SnO_2$ colloidal solution at a rate of 4000 rpm, and then the substrate was annealed on a hot plate at 150 °C for 10 min to obtain an electron transport layer.

A perovskite layer was prepared by using a one-step method. Specifically, the prepared electron transport layer was spin-coated with a perovskite precursor solution at a rate of 4000 rpm for 30 s. 400 $\mu$L of antisolvent chlorobenzene was added dropwise at about 10 s after the start of spin-coating, and then the resulting product was placed on a hot plate and annealed at 110 °C for 60 min to obtain a perovskite layer with a thickness of 500 nm.

A solution of a hole transport material 2,2',7,7'-tetrakis(N,N-di-p-methoxyphenylamine)9,9'-spirobifluorene (Spiro-OMeTAD) in chlorobenzene with a concentration of 72 mg/mL was prepared. The solution was stirred until the material was completely dissolved, and the surface of the perovskite layer was spin-coated with 100 $\mu$L of the solution at 4000 rpm to obtain a hole transport layer with a thickness of about 170 nm. The electron transport layer, the perovskite layer, and the hole transport layer together formed an active layer.

With nickel(II) acetylacetonate as a nickel precursor and water as an oxygen precursor, nickel oxide (NiOx) with a thickness of 20 nm was prepared on the upper surface of the hole transport layer and the side surface of the active layer by atomic layer deposition to serve as a semi-encapsulation layer.

The above products were placed in a vacuum evaporator. When the vacuum degree reached below $5 \times 10^{-4}$ Pa, a Cu metal back electrode with a thickness of 80 nm was deposited at a rate of 0.1 A/s to obtain a solar cell.

The preparation method of Example 2 was substantially the same as that of Example 1, except that in Example 2, Cu(I)(hfac)(TMVS) was used as a copper precursor, water was used as an oxygen precursor, and cuprous oxide with a thickness of 20 nm was prepared on the upper surface of the hole transport layer and the side surface of the active layer by atomic layer deposition to serve as the semi-encapsulation layer.

The preparation method of Example 3 was substantially the same as that of Example 1, except that in Example 3, $SiCl_4$ was used as a silicon precursor, water was used as an oxygen precursor, and silicon dioxide with a thickness of 20 nm was prepared on the upper surface of the hole transport layer and the side surface of the active layer by atomic layer deposition to serve as the semi-encapsulation layer.

The preparation methods of Examples 4 to 7 were substantially the same as the preparation method of Example 1, except that the atomic layer deposition time was adjusted to control the thickness of the semi-encapsulation layer. The specific parameters are shown in Table 1.

In Example 8, nickel oxide with a thickness of 20 nm was sequentially deposited on the upper surface of the hole transport layer and the side surface of the active layer by magnetron sputtering through adjusting the relative angle between the sputtering target and the deposition surface.

Comparative Example 1:

The preparation method was the same as that of Example 1, except that no semi-encapsulation layer was deposited.

Comparative Example 2:

The preparation method was the same as that of Example 3, except that the semi-encapsulation layer was deposited on the upper surface of the hole transport layer by spin-coating.

Comparative Example 3:

The preparation method was the same as that of Example 8, except that the semi-encapsulation layer was deposited on the upper surface of the hole transport layer by magnetron sputtering.

Example 11

The embodiments of the present application provide a manufacturing method for an inverted-structure solar cell. The manufacturing method includes the following steps.

An FTO conductive glass with a size of 2.0 cm $\times$ 2.0 cm was taken, and both ends of the FTO conductive glass were separately subjected to laser etching to remove 0.35 cm of the FTO to expose the glass substrate.

The etched FTO conductive glass was sequentially ultrasonically cleaned with water, acetone, and isopropanol several times.

The FTO conductive glass was dried with a nitrogen gun to remove the solvent, and was further cleaned in an ultraviolet ozone machine.

NiOx with a thickness of about 30 nm was prepared by magnetron sputtering, and was annealed at 300 °C for 60 min to obtain a hole transport layer.

A perovskite layer was prepared by using a one-step method. Specifically, the prepared hole transport layer was spin-coated with a perovskite precursor solution at a rate of 4000 rpm for 30 s. 400 $\mu$L of antisolvent chlorobenzene was added dropwise at about 10 s after the start of spin-coating, and then the resulting product was placed on a hot plate and annealed at 110 °C for 60 min to obtain a perovskite layer with a thickness of 500 nm.

The above products were placed in a vacuum evaporator. When the vacuum degree reached below $5 \times 10^{-4}$ Pa, $C_{60}$ with a thickness of 30 nm was deposited at a rate of 0.05 A/s to obtain an electron transport layer. The electron transport layer, the perovskite layer, and the hole transport layer together formed an active layer.

With tetrakis(dimethylamino)tin as a tin precursor and water as an oxygen precursor, $SnO_2$ with a thickness of 20 nm was deposited on the upper surface of the electron transport layer and the side surface of the active side by atomic layer deposition to serve as a semi-encapsulation layer.

The above products were placed in a vacuum evaporator. When the vacuum degree reached below $5 \times 10^{-4}$ Pa, a Cu metal back electrode with a thickness of 80 nm was deposited at a rate of 0.1 A/s to obtain a solar cell.

The preparation method of Example 12 was substantially the same as that of Example 11, except that in Example 12, $Ti(NMe_2)_4$ was used as a titanium precursor, water was used as an oxygen precursor, and titanium oxide with a thickness of 20 nm was prepared on the upper surface of the electron transport layer and the side surface of the active layer by atomic layer deposition to serve as the semi-encapsulation layer.

The preparation method of Example 13 was substantially the same as that of Example 11, except that in Example 13, $ZnMe_2$ was used as a zinc precursor, water was used as an oxygen precursor, and zinc dioxide with a thickness of 20 nm was prepared on the upper surface of the electron transport layer and the side surface of the active layer by atomic layer deposition to serve as the semi-encapsulation layer.

The preparation method of Example 14 was substantially the same as that of Example 11, except that in Example 14, $SiCl_4$ was used as a silicon precursor, water was used as an oxygen precursor, and silicon dioxide with a thickness of 20 nm was prepared on the upper surface of the electron transport layer and the side surface of the active layer by atomic layer deposition to serve as the semi-encapsulation layer.

The preparation methods of Examples 15 to 18 were substantially the same as the preparation method of Example 1, except that the atomic layer deposition time was adjusted to control the thickness of the semi-encapsulation layer. The specific parameters are shown in Table 3.

In Example 19, tin dioxide with a thickness of 20 nm was sequentially deposited on the upper surface of the electron transport layer and the side surface of the active layer by magnetron sputtering through adjusting the relative angle between the sputtering target and the deposition surface.

Comparative Example 11:

The preparation method was the same as that of Example 11, except that no semi-encapsulation layer was deposited.

Comparative Example 12:

The preparation method was the same as that of Example 14, except that the semi-encapsulation layer was deposited on the upper surface of the hole transport layer by spin-coating.

Comparative Example 13:

The preparation method was the same as that of Example 19, except that the semi-encapsulation layer was deposited on the upper surface of the electron transport layer by magnetron sputtering.

**Test Method**

1. Power conversion efficiency test

The cell performance was tested under a light intensity of 100 mW/cm$^2$ using a Keithley 2400 SMU and an AM 1.5G solar radiation test system, and the power conversion efficiency was calculated as follows:

$$PCE = Pout/Popt$$

$$= Voc \times Jsc \times (Vmpp \times Jmpp)/(Voc \times Jsc \times Popt)$$

$$= Voc \times Jsc \times FF/Popt,$$

where Pout (mW/cm$^2$), Popt (mW/cm$^2$), Vmpp (V), Jmpp (mA/cm$^2$), Voc (V), and Jsc (mA/cm$^2$) denote the output power of the cell, the incident light power, the voltage at the maximum power point of the cell, the current at the maximum power point of the cell, the open-circuit voltage, and the short-circuit current density, respectively. The Jsc short-circuit current density was calculated by dividing the short-circuit current by the area of the solar cell.

2. Stability test

The solar cell was placed on a hot plate at 65 °C for continuous heating, and the change in the power conversion efficiency over aging time was tracked. The time required for the power conversion efficiency to decay to 80% of the initial efficiency was denoted as $T_{80}$, and the magnitude of this parameter indicated the thermal stability of the perovskite solar cell.

**Test Results**

Table 1

| No. | Semi-encapsulation layer | | | $T_{80}$/h |
| --- | --- | --- | --- | --- |
| | Type | Thickness /nm | Preparation method | |
| Example 1 | Nickel oxide | 20 | Atomic layer deposition on surface and side surface | 500 |
| Example 2 | Cuprous oxide | 20 | Atomic layer deposition on surface and side surface | 494 |
| Example 3 | Silicon dioxide | 20 | Atomic layer deposition on surface and side surface | 496 |
| Example 4 | Nickel oxide | 30 | Atomic layer deposition on surface and side surface | 460 |
| Example 5 | Nickel oxide | 35 | Atomic layer deposition on surface and side surface | 450 |
| Example 6 | Nickel oxide | 10 | Atomic layer deposition on surface and side surface | 465 |
| Example 7 | Nickel oxide | 5 | Atomic layer deposition on surface and side surface | 445 |
| Example 8 | Nickel oxide | 20 | Magnetron sputtering deposition on surface and side surface | 480 |
| Comparative Example 1 | / | / | / | 380 |
| Comparative Example 2 | Silicon dioxide | 20 | Spin-coating deposition on surface | 400 |
| Comparative Example 3 | Nickel oxide | 20 | Magnetron sputtering deposition on surface | 415 |

Table 2

| No. | Semi-encapsulation layer | | | PCE(%) |
| --- | --- | --- | --- | --- |
| | Type | Thickness /nm | Preparation method | |
| Example 1 | Nickel oxide | 20 | Atomic layer deposition on surface and side surface | 21.70 |
| Example 2 | Cuprous oxide | 20 | Atomic layer deposition on surface and side surface | 21.43 |
| Example 3 | Silicon dioxide | 20 | Atomic layer deposition on surface and side surface | 17.79 |
| Example 4 | Nickel oxide | 30 | Atomic layer deposition on surface and side surface | 20.46 |
| Example 5 | Nickel oxide | 35 | Atomic layer deposition on surface and side surface | 19.31 |

(continued)

| No. | Semi-encapsulation layer | | | PCE(%) |
| --- | --- | --- | --- | --- |
| | Type | Thickness /nm | Preparation method | |
| Example 6 | Nickel oxide | 10 | Atomic layer deposition on surface and side surface | 20.95 |
| Example 7 | Nickel oxide | 5 | Atomic layer deposition on surface and side surface | 19.54 |
| Example 8 | Nickel oxide | 20 | Magnetron sputtering deposition on surface and side surface | 19.19 |
| Comparative Example 2 | Silicon dioxide | 20 | Spin-coating deposition on surface | 16.95 |

The cells in the examples and comparative examples in Tables 1 and 2 were all regular-structure solar cells. As can be seen from the comparison between Examples 1 to 8 and Comparative Examples 1 to 3, providing a semi-encapsulation layer between the hole transport layer and the second electrode layer of the regular-structure solar cell could effectively improve the stability of the solar cell, in which the semi-encapsulation layer included a planar portion located between the active layer and the second electrode layer and an encapsulating portion located on at least one side surface of the active layer. As can be seen from Examples 1 to 3, in the regular-structure solar cell including a p-type semiconductor material such as nickel oxide or cuprous oxide, compared with the case including an insulator silicon dioxide, both the stability and the power conversion efficiency of the solar cell were improved.

As can be seen from Examples 4 to 7, when the thickness of the planar portion of the semi-encapsulation layer and/or the encapsulating portion of the semi-encapsulation layer of the regular-structure solar cell was 5 nm to 35 nm, the solar cell achieved high stability and power conversion efficiency. When the thickness of the planar portion of the semi-encapsulation layer and/or the encapsulating portion of the semi-encapsulation layer of the regular-structure solar cell was 10 nm to 30 nm, the stability and power conversion efficiency of the solar cell were further improved.

As can be seen from the comparison between Example 1 and Example 8, compared with the semi-encapsulation layer prepared by using the magnetron sputtering method, the semi-encapsulation layer prepared by using the atomic layer deposition method could further improve the stability and power conversion efficiency of the solar cell.

Table 3

| No. | Semi-encapsulation layer | | | $T_{80}$/h |
| --- | --- | --- | --- | --- |
| | Type | Thickness/nm | Preparation method | |
| Example 11 | Tin dioxide | 20 | Atomic deposition on surface and side surface | 650 |
| Example 12 | Titanium dioxide | 20 | Atomic deposition on surface and side surface | 642 |
| Example 13 | Zinc oxide | 20 | Atomic deposition on surface and side surface | 646 |
| Example 14 | Silicon dioxide | 20 | Atomic deposition on surface and side surface | 630 |
| Example 15 | Tin dioxide | 30 | Atomic deposition on surface and side surface | 620 |
| Example 16 | Tin dioxide | 35 | Atomic deposition on surface and side surface | 615 |
| Example 17 | Tin dioxide | 10 | Atomic deposition on surface and side surface | 610 |
| Example 18 | Tin dioxide | 5 | Atomic deposition on surface and side surface | 608 |
| Example 19 | Tin dioxide | 20 | Magnetron sputtering deposition on surface and side surface | 621 |
| Comparative Example 11 | / | / | / | 550 |
| Comparative Example 12 | Silicon dioxide | 20 | Spin-coating deposition on surface | 560 |

(continued)

| No. | Semi-encapsulation layer | | | $T_{80}$/h |
| | Type | Thickness/nm | Preparation method | |
|---|---|---|---|---|
| Comparative Example 13 | Tin dioxide | 20 | Magnetron deposition on surface | 571 |

Table 4

| No. | Semi-encapsulation layer | | | PCE(%) |
| | Type | Thickness /nm | Preparation method | |
|---|---|---|---|---|
| Example 11 | Tin dioxide | 20 | Atomic deposition on surface and side surface | 19.77 |
| Example 12 | Titanium dioxide | 20 | Atomic deposition on surface and side surface | 19.32 |
| Example 13 | Zinc oxide | 20 | Atomic deposition on surface and side surface | 19.45 |
| Example 14 | Silicon dioxide | 20 | Atomic deposition on surface and side surface | 15.41 |
| Example 15 | Tin dioxide | 30 | Atomic deposition on surface and side surface | 18.78 |
| Example 16 | Tin dioxide | 35 | Atomic deposition on surface and side surface | 18.01 |
| Example 17 | Tin dioxide | 10 | Atomic deposition on surface and side surface | 18.66 |
| Example 18 | Tin dioxide | 5 | Atomic deposition on surface and side surface | 18.29 |
| Example 19 | Tin dioxide | 20 | Magnetron sputtering deposition on surface and side surface | 19.22 |
| Comparative Example 12 | Silicon dioxide | 20 | Spin-coating deposition on surface | 14.59 |

The cells in the examples and comparative examples in Tables 3 and 4 were all inverted-structure solar cells. As can be seen from the comparison between Examples 11 to 19 and Comparative Examples 11 to 13, providing a semi-encapsulation layer between the electron transport layer and the second electrode layer of the inverted-structure solar cell could effectively improve the stability of the solar cell, in which the semi-encapsulation layer included a planar portion located between the active layer and the second electrode layer and an encapsulating portion located on at least one side surface of the active layer.

As can be seen from Examples 11 to 14, in the inverted-structure solar cell including an n-type semiconductor material such as tin dioxide, titanium dioxide, and zinc dioxide, compared with the case including an insulator silicon dioxide, both the stability and the power conversion efficiency of the solar cell were improved.

As can be seen from Examples 15 to 18, when the thickness of the planar portion of the semi-encapsulation layer and/or the encapsulating portion of the semi-encapsulation layer of the inverted-structure solar cell was 5 nm to 35 nm, the solar cell achieved high stability and power conversion efficiency. When the thickness of the planar portion of the semi-encapsulation layer and/or the encapsulating portion of the semi-encapsulation layer of the inverted-structure solar cell was 10 nm to 30 nm, the stability and power conversion efficiency of the solar cell were further improved.

As can be seen from the comparison between Example 11 and Example 19, compared with the semi-encapsulation layer prepared by using the magnetron sputtering method, the semi-encapsulation layer prepared by using the atomic layer deposition method could further improve the stability and power conversion efficiency of the solar cell.

Finally, it should be noted that the above embodiments are only used to illustrate the technical solutions of the present application, rather than limit the same. Although the present application has been described in detail with reference to the foregoing embodiments, those of ordinary skill in the art should understand that modifications can still be made to the technical solutions recorded in the foregoing embodiments, or equivalent substitutions to some or all of the technical features can be made. However, such modifications or substitutions do not make the spirit of the corresponding technical solutions deviate from the scope of the technical solutions in the embodiments of the present application, and shall all fall within the scope of the claims and specification of the present application. In particular, the technical features mentioned in the embodiments can be combined in any manner, provided that there is no structural conflict. The present application is not limited to the specific embodiments disclosed herein, but encompasses all technical solutions falling within the scope of the claims.

**Claims**

1. A solar cell, comprising:

   a first electrode layer, an active layer, and a second electrode layer that are sequentially stacked, and
   a semi-encapsulation layer, wherein the semi-encapsulation layer comprises a planar portion located between the active layer and the second electrode layer and an encapsulating portion at least partially located on at least one side surface of the active layer.

2. The solar cell according to claim 1, wherein
   the semi-encapsulation layer comprises a semiconductor material.

3. The solar cell according to claim 1 or 2, wherein
   the semi-encapsulation layer is prepared by using an atomic layer deposition method.

4. The solar cell according to any one of claims 1 to 3, wherein
   a thickness of the planar portion of the semi-encapsulation layer and/or the encapsulating portion of the semi-encapsulation layer is 5 nm to 35 nm.

5. The solar cell according to any one of claims 1 to 4, wherein
   the thickness of the planar portion of the semi-encapsulation layer and/or the encapsulating portion of the semi-encapsulation layer is 10 nm to 30 nm.

6. The solar cell according to any one of claims 1 to 5, wherein
   the solar cell is a regular-structure solar cell, the active layer comprises an electron transport layer, a perovskite layer, and a hole transport layer that are sequentially stacked, and the hole transport layer is located between the perovskite layer and the semi-encapsulation layer; the semi-encapsulation layer comprises a p-type semiconductor material.

7. The solar cell according to claim 6, wherein
   the p-type semiconductor material includes at least one of nickel oxide, cuprous oxide, cuprous iodide, silver iodide, and molybdenum oxide.

8. The solar cell according to any one of claims 1 to 5, wherein
   the solar cell is an inverted-structure solar cell, the active layer comprises a hole transport layer, a perovskite layer, and an electron transport layer that are sequentially stacked, and the electron transport layer is located between the perovskite layer and the semi-encapsulation layer; the semi-encapsulation layer comprises an n-type semiconductor material.

9. The solar cell according to claim 8, wherein
   the n-type semiconductor material comprises at least one of tin dioxide, titanium dioxide, zinc oxide, indium oxide, and gallium oxide.

10. A preparation method for a solar cell, the preparation method comprising:

    providing a first electrode layer and an active layer that are sequentially stacked;
    preparing a semi-encapsulation layer on an upper side of the active layer and at least one side surface of the active layer, wherein the semi-encapsulation layer comprises a planar portion located on the upper side of the active layer and an encapsulating portion located on at least one side surface of the active layer; and
    providing a second electrode layer on an upper side of the planar portion of the semi-encapsulation layer.

11. The preparation method according to claim 10, wherein the preparation method specifically comprises:
    preparing a semi-encapsulation layer on the upper side of the active layer and at least one side surface of the active layer by using an atomic layer deposition method, wherein the semi-encapsulation layer comprises a semiconductor material.

12. The preparation method according to claim 10 or 11, wherein
the solar cell is a regular-structure solar cell, the active layer comprises an electron transport layer, a perovskite layer, and a hole transport layer that are sequentially stacked, and the hole transport layer is located between the perovskite layer and the semi-encapsulation layer; the semi-encapsulation layer comprises a p-type semiconductor material.

13. The preparation method according to claim 10 or 11, wherein
the solar cell is an inverted-structure solar cell, the active layer comprises a hole transport layer, a perovskite layer, and an electron transport layer that are sequentially stacked, and the electron transport layer is located between the perovskite layer and the semi-encapsulation layer; the semi-encapsulation layer comprises an n-type semiconductor material.

14. An electric device, comprising the solar cell according to any one of claims 1 to 9 or a solar cell prepared by using the preparation method according to any one of claims 10 to 13.

**1-1**

FIG. 1

**1-2**

FIG. 2

**1-3**

FIG. 3

## INTERNATIONAL SEARCH REPORT

| International application No. |
|---|
| **PCT/CN2024/070953** |

**A. CLASSIFICATION OF SUBJECT MATTER**

H10K 30/85(2023.01)i; H10K 71/16(2023.01)i; H10K 30/88(2023.01)i

According to International Patent Classification (IPC) or to both national classification and IPC

**B. FIELDS SEARCHED**

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

CNTXT: CNABS; CNKI; VEN; USTXT; EPTXT; WOTXT: 钙钛矿, 太阳, 电池, 光伏, 光生伏打, 包封, 包覆, 包绕, 覆盖, 封装, 密封, 侧, 活性层, 吸光层, 光敏层, perovskite, solar, cell, photovoltaic, encapsulat+, clad, wrap, cover, seal, side, active layer, light absorbing layer, light sensitive layer

**C. DOCUMENTS CONSIDERED TO BE RELEVANT**

| Category* | Citation of document, with indication, where appropriate, of the relevant passages | Relevant to claim No. |
|---|---|---|
| X | CN 113178521 A (NANJING UNIVERSITY) 27 July 2021 (2021-07-27) description, paragraphs [0002]-[0156], and figures 1-5 | 1-14 |
| X | CN 109786564 A (SVOLT ENERGY TECHNOLOGY CO., LTD.) 21 May 2019 (2019-05-21) description, paragraphs [0002]-[0070], and figures 1-7 | 1-14 |
| X | CN 113054106 A (WAYS TECHNICAL CORP., LTD.) 29 June 2021 (2021-06-29) description, paragraphs [0002]-[0054], and figures 1-11 | 1-14 |
| X | CN 213905399 U (KUNSHAN XIEXIN PHOTOELECTRIC MATERIAL CO., LTD. et al.) 06 August 2021 (2021-08-06) description, paragraphs [0002]-[0051], and figures 1-4 | 1-14 |
| A | CN 107210368 A (KOREA UNIVERSITY RESEARCH AND BUSINESS FOUNDATION) 26 September 2017 (2017-09-26) entire document | 1-14 |
| A | CN 216980609 U (BYD CO., LTD.) 15 July 2022 (2022-07-15) entire document | 1-14 |

☐ Further documents are listed in the continuation of Box C.     ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **19 February 2024** | **03 March 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
**Information on patent family members**

International application No.

**PCT/CN2024/070953**

| Patent document cited in search report | | | Publication date (day/month/year) | Patent family member(s) | | | Publication date (day/month/year) |
|---|---|---|---|---|---|---|---|
| CN | 113178521 | A | 27 July 2021 | None | | | |
| CN | 109786564 | A | 21 May 2019 | CN | 109786564 | B | 22 April 2022 |
| CN | 113054106 | A | 29 June 2021 | None | | | |
| CN | 213905399 | U | 06 August 2021 | None | | | |
| CN | 107210368 | A | 26 September 2017 | WO | 2016186317 | A1 | 24 November 2016 |
| | | | | KR | 20160135408 | A | 28 November 2016 |
| | | | | KR | 101852237 | B1 | 25 April 2018 |
| | | | | CN | 107210368 | B | 08 November 2019 |
| CN | 216980609 | U | 15 July 2022 | None | | | |

Form PCT/ISA/210 (patent family annex) (July 2022)

**EP 4 750 281 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310967008